# FASCICULE DE BREVET EUROPEEN

(11) **EP 3 589 099 B1**
(45) Date de publication et mention de la délivrance du brevet: **16.04.2025**
(21) Numéro de dépôt: 19179452.8
(22) Date de dépôt: 11.06.2019
(51) Int. Cl.: H05K 7/20, H05K 7/14

(54) **ÉQUIPEMENT ÉLECTRIQUE COMPRENANT UN DISPOSITIF DE PLAQUE SUPPORT DE DISSIPATION**
ELEKTRISCHE AUSRÜSTUNG, DIE EINE VORRICHTUNG EINER HALTERUNGSPLATTE ZUR ABLEITUNG UMFASST
ELECTRICAL EQUIPMENT COMPRISING A DISSIPATING SUPPORT PLATE DEVICE

(30) Priorité: 28.06.2018 FR 1855873
(43) Date de publication de la demande: 01.01.2020
(73) Titulaire: Valeo Electrification, 95800 Cergy (FR)
(72) Inventeur: TRAMET, Guillaume, 78360 MONTESSON (FR); MAS, Arnaud, 95000 CERGY (FR); BEAUDOUX, Benoît, 75013 PARIS (FR)
(74) Mandataire: Valeo Powertrain Systems

(56) Documents cités:
- WO-A1-2014/057622
- US-A1- 2006 044 762
- US-A1- 2013 301 220
- US-A1- 2013 314 966

## Description

### DOMAINE TECHNIQUE ET OBJET DE L'INVENTION

La présente invention concerne un équipement électrique comportant une plaque support de dissipation de chaleur, ladite plaque support de dissipation étant destinée à recevoir une carte électronique en mezzanine.

L'invention se rapporte par exemple au domaine des équipements électriques, notamment haute tension et destinés pour véhicules électriques et hybrides.

### ETAT DE LA TECHNIQUE

Dans un équipement électrique, tel qu'un onduleur, comme cela est connu, un boîtier héberge une ou plusieurs cartes électroniques. Par exemple, un équipement électrique peut comporter une carte électronique, par exemple une carte électronique de commande, pouvant être installée en mezzanine sur une plaque support, en vis-à-vis d'un module électronique de puissance.

Il est connu que de telles cartes électroniques émettent de la chaleur. Notamment, une carte électronique de commande produit de la chaleur lors de son fonctionnement, nécessitant la dissipation d'une puissance calorifique de l'ordre de 5 W.

Pour comparaison, un module électronique de puissance doit quant à lui dissiper une chaleur d'une puissance de l'ordre de 2 kW. À cet effet, le module électronique de puissance peut être mis en en contact avec un dissipateur thermique recevant un fluide de refroidissement.

Une problématique réside dans la dissipation de la chaleur produite par la carte électronique, en particulier dans le contexte où ladite chaleur est localisée sur une carte électronique installée en mezzanine, sur une plaque support. Il faut en effet trouver un chemin de dissipation de la chaleur jusqu'au fluide de refroidissement.

Le document WO 2014/057622 A1 décrit un module électronique avec une carte électronique disposée en mezzanine sur des éléments de support recourbés permettant de drainer une partie de la chaleur émise par la carte électronique en mezzanine.

Il est à noter que la présente invention est décrite en particulier pour une mise en oeuvre dans un équipement électrique, notamment dans un onduleur, en particulier dans un véhicule électrique ou hybride, sans que celle-ci ne doive être interprétée comme une limitation.

Dans ce dernier cas, le véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension.

La batterie d'alimentation haute tension assure une fonction d'alimentation en énergie du système de motorisation électrique permettant la propulsion du véhicule. Afin de commander la machine électrique entrainant les roues du véhicule, il est connu d'utiliser un onduleur permettant de convertir le courant continu fourni par la batterie d'alimentation haute tension en un ou plusieurs courants de commande alternatifs.

L'onduleur comprend des composants électroniques par lesquels passe l'énergie alimentant le système de motorisation électrique. Classiquement, les composants électroniques sont agencés sous la forme d'un module électronique de puissance. L'onduleur comprend aussi une unité de commande comprenant des composants électroniques permettant de commander les composants électroniques de l'onduleur.

Le module électronique de puissance comprend un boîtier contenant les composants électroniques. Le module électronique de puissance comporte ainsi des composants électroniques de puissance par lesquels passe de l'énergie alimentant une machine électrique. Ces composants électroniques de puissance peuvent comprendre des interrupteurs électroniques, tels que par exemple des transistors semi-conducteurs, et sont agencés en circuit électrique pour permettre un passage commandé d'énergie électrique entre une batterie d'alimentation et la machine électrique. En particulier, les composants électroniques de puissance sont des puces semi-conductrices nues pour lesquels le boîtier réalise une encapsulation. Autrement dit, un seul boîtier réalise le conditionnement de toutes les puces semi-conductrices nues du module électronique de puissance.

Le boîtier du module électronique de puissance peut comprendre des conducteurs électriques permettant d'alimenter les composants électroniques du module électronique de puissance. En outre, le module électronique de puissance peut être associé à une unité électronique de pilotage, autrement dit une carte « driver », permettant de délivrer des niveaux de tension adaptés à la commande des composants électroniques du module électronique de puissance, à partir de signaux délivrés par l'unité de commande.

De façon générale, la présente invention s'applique à un équipement électrique comprenant un module électronique de puissance, une carte électronique disposée en mezzanine sur une plaque support, avec un besoin de dissipation de la chaleur produite par ladite carte électronique disposée en mezzanine.

Dans ce but, la présente invention concerne une plaque support de dissipation destinée à recevoir une carte électronique, en mezzanine par rapport à un module électronique de puissance, ladite plaque comprenant au moins un plot configuré pour drainer la chaleur produite par des composants intégrés à ladite carte électronique , afin de permettre la dissipation de ladite chaleur, notamment par diffusion dans la plaque support et par l'intermédiaire de la mise en contact dudit plot avec la plaque de dissipation thermique du module électronique de puissance.

### PRESENTATION GENERALE DE L'INVENTION

A cet effet, plus précisément, l'invention a tout d'abord pour objet un équipement électrique tel que décrit dans la revendication 1.

Avantageusement, outre ledit au moins un plot, la plaque support de dissipation comprend au moins un autre moyen de dissipation de la chaleur produite par la carte électronique, parmi le matériau constitutif de la zone de réception, et l'organisation d'un contact surfacique entre la carte électronique et ladite zone de réception de la plaque support de dissipation.

Le diamètre du fut peut être configuré pour améliorer la dissipation de chaleur. Selon un mode de réalisation, ladite plaque support de dissipation assure une fonction de bouclier électromagnétique entre le module électronique de puissance et la carte électronique. Selon une forme de réalisation, une première face de la plaque de dissipation thermique du module électronique de puissance forme une face externe de dissipation thermique du module électronique de puissance et dans lequel les composants électroniques sont montés sur une deuxième face de la plaque de dissipation du module électronique de puissance opposée à la première face.

Selon un mode de réalisation, la deuxième face de la plaque de dissipation thermique du module électronique de puissance comprend au moins une portion formant une surface externe du module électronique de puissance, une extrémité dudit au moins un plot venant en appui contre ladite portion.

Selon un mode de réalisation, ledit boîtier comprend une paroi, notamment en matériau isolant électrique, s'étendant depuis la deuxième face de la plaque de dissipation thermique, ladite paroi étant fermée de façon à définir un logement recevant les composants électroniques du module électronique de puissance.

Notamment la paroi est rapportée le long du contour de ladite plaque de dissipation thermique.

Notamment, la paroi est surmoulée sur la plaque de dissipation thermique.

La présente invention vise aussi un équipement électrique, dans lequel ladite portion externe de la deuxième face de la plaque de dissipation thermique est une surface délimitée par un bord de la plaque de dissipation thermique et une face externe de ladite plaque.

Selon un mode de réalisation, l'équipement électrique comprend un châssis comportant :
- des premiers organes de retenue configurés pour fixer ladite plaque support de dissipation avec ledit châssis et
- des seconds organes de retenue, configurés pour fixer ledit module électronique de puissance avec ledit châssis,
de sorte que la plaque support de dissipation et le module électronique de puissance sont solidaires l'un de l'autre par l'intermédiaire dudit châssis indépendamment de tout autre moyen de fixation.

Selon un mode de réalisation, ladite plaque support de dissipation comprend des premiers organes de retenue complémentaires pour clipper ladite plaque support de dissipation avec ledit châssis et ledit module électronique de puissance comprend des seconds organes de retenue complémentaires pour clipper ledit module électronique de puissance avec ledit châssis.

Avantageusement, les premiers organes de retenue sont des ergots et les organes de retenue complémentaires sont des dépressions aménagées dans ladite plaque support de dissipation.

La présente invention couvre aussi un ensemble électrique comprenant un équipement électrique tel que brièvement décrit ci-dessus, et un dissipateur thermique contre lequel l'équipement électrique est rapporté, la plaque de dissipation thermique, en particulier sa face externe, venant contre une face du dissipateur thermique et l'ensemble étant fixé au dissipateur thermique par l'intermédiaire d'une mise en appui du plot sur la plaque de dissipation thermique et le dissipateur thermique.

Notamment par l'intermédiaire d'une tige, en particulier une vis de fixation, reçue dans le plot, la plaque de dissipation thermique du module électronique de puissance et le dissipateur thermique. Notamment, ledit au moins un plot comprend un fut traversant pour permettre le passage d'une vis de fixation.

L'invention concerne également un onduleur comprenant un ensemble électrique tel que brièvement décrit ci-dessus.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1 montre une plaque support de dissipation selon l'invention, dans un équipement électrique représenté partiellement,
- la figure 2 représente une vue en coupe montrant la plaque support de dissipation selon l'invention,
- la figure 3 montre le drainage de chaleur par une plaque support de dissipation selon l'invention,
- la figure 4 montre la fonction de bouclier électromagnétique assurée par une plaque support de dissipation selon l'invention,
- la figure 5 montre le passage de vis de fixation dans des futs aménagés dans les plots d'une plaque support de dissipation selon l'invention,
- la figure 6 représente une vue partielle du boîtier de l'équipement électrique, faisant apparaître des moyens de retenue de la plaque support de dissipation.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

Dans la description ci-après, l'invention est principalement décrite dans son application à un équipement électrique pour un véhicule automobile électrique ou hybride, sans que cela ne soit limitatif de la portée de la présente invention.

En outre, comme expliqué précédemment, la présente invention est principalement décrite en vue d'une mise en oeuvre dans un onduleur mais est applicable à tout équipement électrique comprenant notamment une carte électronique disposée en mezzanine sur une plaque support, avec un besoin de dissipation de la chaleur produite par ladite carte électronique disposée en mezzanine.

Une plaque support permettant l'installation d'une carte électronique en mezzanine, notamment au-dessus d'une autre carte électronique, dans un boîtier d'un équipement électrique, est couramment désignée sous le terme de « bracket » en langue anglaise.

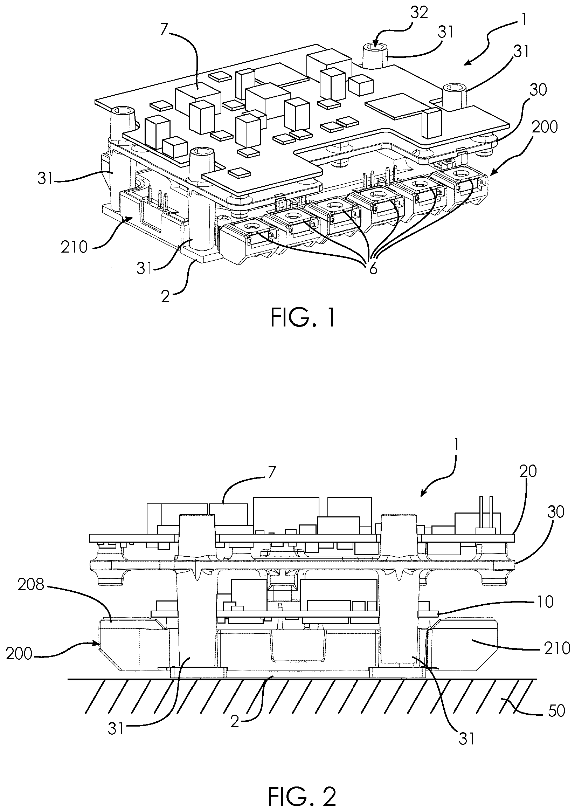

Comme représenté sur les figure 1 à 5, la plaque support 30 est prévue pour être fixer sur une plaque de dissipation thermique 2 d'un module électronique de puissance. La plaque support 30 assure d'abord une fonction d'interface de maintien mécanique de la carte électronique 20 disposée en mezzanine. Autrement dit, la plaque support 30 - ou « bracket » - permet la superposition de la carte électronique 20 en vis-à-vis du module électronique de puissance.

Selon l'invention, une telle plaque support 30 est configurée pour drainer des calories issues de la carte électronique 20 qu'elle supporte, et, le cas échéant, pour assurer une fonction de bouclier électromagnétique - également désigné bouclier OEM pour Ondes Electromagnétiques - et/ou, de façon complémentaire, pour assurer une fonction de reprise de masse au bénéfice de ladite carte électronique 20 en mezzanine.

En particulier, il est prévu de mettre en oeuvre la plaque support de dissipation 30 dans un équipement électrique comprenant un module électronique de puissance 200. Le module électronique de puissance comprend un boîtier 208 comportant une paroi 210, et une plaque de dissipation thermique 2.

Notamment, la paroi 210 du boîtier 208 peut comporter des premiers moyens de retenue, ladite plaque support de dissipation 30 comprenant des moyens complémentaires de retenue pour clipper ladite plaque support de dissipation 30 dans ladite ceinture.

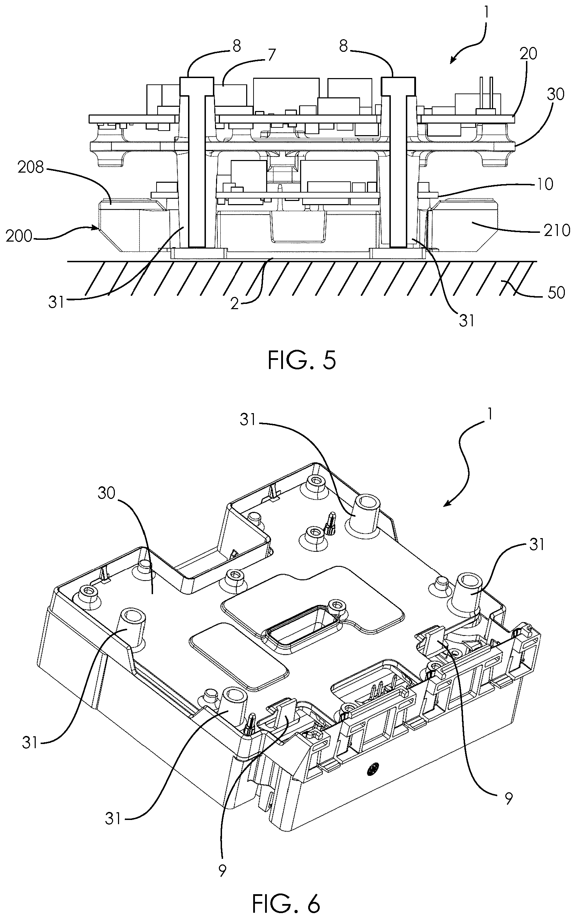

Par exemple, les premiers moyens de retenue sont des ergots et les moyens complémentaires de retenue sont des dépressions aménagées dans ladite plaque support de dissipation 30. A la figure 6, il est représenté une vue en perspective au travers du boîtier de l'équipement électrique. Selon cette forme de réalisation, des ergots 9 retiennent la plaque support de dissipation 30 en se clipant à la bordure périphérique de ladite plaque support de dissipation.

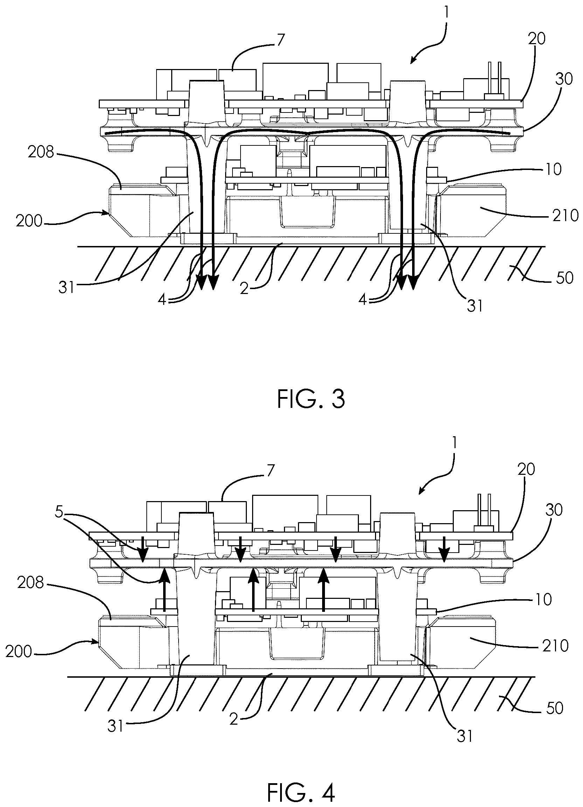

En référence aux figure 1 à 5, une première carte électronique 10 est disposée à même le module électronique de puissance 200. La plaque support de dissipation 30 est fixée à la plaque de dissipation thermique 2 par l'intermédiaire de vis 3 engagées dans des futs 32 aménagés dans les plots 31 correspondants, comme le montre la figure 5. Sur ladite plaque support de dissipation 30 est disposée, une seconde carte électronique 20 de façon à se trouver en mezzanine vis-à-vis du module électronique de puissance 200. En référence à la figure 3 notamment, la plaque support de dissipation 30 a pour fonction de dissiper une partie de la chaleur émise par la seconde carte électronique 20 dans la plaque support de dissipation 30, jusqu'à la plaque de dissipation thermique 2 où ladite chaleur se dissipe, notamment, par exemple, à l'aide d'un circuit de refroidissement (non représenté) agencé au contact ou à proximité de ladite plaque de dissipation thermique 2.

En référence aux figures 2 et 3, la présente invention vise ainsi à favoriser le refroidissement de la carte électronique 20 disposée en mezzanine en vis-à-vis du module électronique de puissance 200, en dissipant de la chaleur dans la plaque support de dissipation 30, recevant ladite carte électronique 20 et en drainant, la chaleur vers ladite plaque de dissipation thermique 2 au moyen de plots 31. Les plots 31 permettent par ailleurs la fixation de la plaque support de dissipation 30 à ladite plaque de dissipation thermique 2. Ladite plaque de dissipation thermique peut ensuite venir au contact d'un circuit de refroidissement (non représenté). Sur la figure 3, les flèches 4 montrent les flux de chaleur drainée de la carte électronique 20 vers le plaque de dissipation thermique 2.

Dans un exemple de mise en oeuvre de la présente invention, on se situe dans un véhicule, notamment un véhicule automobile. Ledit véhicule comprend notamment une machine électrique, un onduleur et une batterie d'alimentation haute tension.

L'onduleur comporte alors un équipement électrique 1 comprenant les deux cartes électroniques 10, 20, la première, disposée directement sur le boîter du module électronique de puissance 200, étant une unité de pilotage, autrement dit une carte « driver », et la seconde étant une unité de commande disposée en mezzanine sur une plaque support de dissipation 30 selon l'invention.

En particulier, selon ce mode de réalisation, le module électronique de puissance 200 comprend des composants électroniques de puissance par lesquels passe l'énergie alimentant la machine électrique via des conducteurs électriques 6, lesdits composants électroniques étant notamment destinés à transformer un courant continu délivré par la batterie d'alimentation en courants alternatifs, ou vice-versa. Ces composants électroniques de puissance peuvent comprendre des interrupteurs électroniques, tels que par exemple des transistors semi-conducteurs, agencés en circuit électrique pour permettre un passage commandé d'énergie électrique entre la batterie d'alimentation et la machine électrique. En particulier, les composants électroniques 7 comprennent des puces semi-conductrices nues pour lesquelles le boîtier 208 du module électronique de puissance 200 réalise une encapsulation. Autrement dit, un seul boîtier 208 réalise le conditionnement de toutes les puces semi-conductrices nues du module électronique de puissance.

L'équipement électrique 1 est par exemple refroidi au moyen d'un circuit de refroidissement (non représenté) connecté à la plaque de dissipation thermique 2 du boîtier 208 dudit module électronique de puissance 200.

Comme cela est montré sur les modes de réalisation des figure 1 à 5, la seconde carte électronique, par exemple une unité de commande 20, est disposée en mezzanine sur une zone de réception de la plaque support de dissipation 30. La chaleur émise par les composants électroniques 7 qu'elle comporte est drainée et dissipée grâce à la plaque support de dissipation 30.

A cette fin, la plaque support de dissipation 30 comprend les plots 31.

Les plots 31 relient mécaniquement, et thermiquement, la plaque support de dissipation 30, et notamment la zone de réception de la carte électronique disposée en mezzanine, à une paroi d'un boîtier de module électronique de puissance 200. En particulier, les plots 31 relient la zone de réception de la plaque support de dissipation 30 à la plaque de dissipation thermique 2 du boîtier du module électronique de puissance 200. Notamment, les plots 31 comprennent des futs 32 destinés à permettre le passage des vis de fixation 3 de la plaque support de dissipation 30 à la plaque de dissipation thermique 2 du boîtier 208.

Les plots 31 sont configurés pour drainer la chaleur de la carte électronique 20 disposée en mezzanine. Notamment, le diamètre des plots 31 et des futs 32 éventuels qu'ils comprennent sont configurés pour maximiser le drainage de chaleur depuis la zone de réception de la carte électronique 20 disposée en mezzanine.

La chaleur émise par ladite carte électronique 20 disposée en mezzanine, notamment par les composants électroniques, est ainsi captée par la plaque support de dissipation 30 et drainée par les plots 31 pour être amenée à la plaque de dissipation thermique 2 du module électronique de puissance 200 puis à un dissipateur thermique contre lequel est monté la plaque de dissipation thermique 2 du module électronique de puissance.

Toujours dans ce but de dissiper la chaleur émise par la carte électronique 20 disposée en mezzanine contre la plaque support de dissipation 30, selon un mode de réalisation, ladite plaque support de dissipation 30 est constituée d'un matériau conducteur thermique et un contact, notamment surfacique, est organisé entre ladite carte électronique 20 disposée en mezzanine et la face supérieure de la plaque support de dissipation 30, comprenant la zone de réception de ladite carte électronique 20, afin de favoriser la dissipation de chaleur dans la masse de la plaque support de dissipation 30.

Selon un mode de réalisation, il est par ailleurs prévu d'aménager des ouvertures dans le plaque de dissipation thermique 2, lesdites ouvertures étant en vis-à-vis avec des passages traversants de la plaque support de dissipation 30, notamment des futs 31. Des vis sont destinées à venir dans ces passages traversants et ces ouvertures pour fixer l'ensemble comprenant le module électronique de puissance 200, la plaque support de dissipation 30 supportant la carte électronique 20 disposée en mezzanine avec un support. Un tel support comprend notamment un dissipateur thermique contre lequel la plaque de dissipation thermique 2 vient en appui.

La zone de réception de la plaque support de dissipation 30, tout comme le boîtier 208, peuvent également comprendre des ergots ou des plots secondaires assurant une fonction de pilotis pour supporter respectivement chaque carte électronique 10, 20. En particulier, le boîtier 208 et/ou la zone de réception de la plaque support de dissipation 30 peuvent comprendre des moyens de pincement prenant en sandwich la carte électronique 10, 20 qu'ils supportent respectivement, afin d'empêcher leur vibration et, s'agissant en particulier de la carte électronique 20 disposée en mezzanine, afin de bien drainer la chaleur émise.

Le dissipateur thermique 50 est alors par exemple intégré dans un ensemble électrique, par exemple un onduleur, dans lequel est destiné à être monté le module électronique de puissance 200, et la plaque support de dissipation 30.

Par ailleurs, la plaque support de dissipation 30 assure en outre de préférence une fonction de bouclier électromagnétique. Notamment, à cette fin, la plaque support de dissipation 30 est constituée de métal.

La figure 4 représente ladite fonction de bouclier électromagnétique en montrant des flux électromagnétiques 5 issus de la carte électronique 20 disposée en mezzanine ou de la première carte électronique 10 reçue directement par le boîtier 208 du module électronique de puissance 2, selon ce mode de réalisation dans lequel, en particulier, ladite plaque support de dissipation 30 est constituée de métal, empêche les flux électromagnétiques émis par une carte électronique 10, 20 de perturber l'autre carte électronique 20, 10.

Il est précisé que, selon un mode de réalisation, la plaque support de dissipation 30 est obtenue par moulage, sans nécessiter d'usinage ensuite.

## Revendications

1. Equipement électrique (1) comprenant :
- un module électronique de puissance (200) comprenant un boîtier (208) et des composants électroniques contenus dans ledit boîtier, et
- une carte électronique (20), notamment configurée pour commander les composants électroniques du module électronique de puissance (200) ;
- un dispositif de plaque support de dissipation (30), ladite plaque support de dissipation (30) comprenant :
- une face, dite face de réception, contre laquelle la carte électronique (20) est reçue de manière à être disposée en mezzanine en vis-à-vis du module électronique de puissance (200), et
l'équipement électrique étant **caractérisé en ce que** ladite plaque support de dissipation comprend également :
- du côté opposé à ladite face de réception, au moins un plot (31) pour supporter la plaque support de dissipation (30) dans une zone de réception de la carte électronique (20), ledit au moins un plot (31) comprenant en outre un fut (32) traversant pour permettre le passage d'une vis de fixation (3) de sorte à fixer la plaque support de dissipation (30) à une plaque de dissipation thermique (2) appartenant au boîtier du module électronique de puissance (200), et ledit au moins un plot (31) étant configuré pour drainer de la chaleur issue de la carte électronique (20) afin d'en permettre la dissipation via la plaque de dissipation thermique (2) du module électronique de puissance (200).

2. Equipement électrique (1) selon la revendication 1, dans lequel une première face de la plaque de dissipation thermique du module électronique de puissance (200) forme une face externe de dissipation thermique du module électronique de puissance (200) et dans lequel les composants électroniques sont montés sur une deuxième face de la plaque de dissipation thermique du module électronique de puissance (200) opposée à la première face.

3. Equipement électrique (1) selon la revendication 2, dans lequel la deuxième face de la plaque de dissipation thermique (2) du module électronique de puissance (200) comprend au moins une portion formant une surface externe du module électronique de puissance (200), une extrémité dudit plot (31) venant en appui contre ladite portion.

4. Equipement électrique (1) selon l'une des revendications précédentes, dans lequel ledit boîtier comprend une paroi, notamment en matériau isolant électrique, s'étendant depuis la deuxième face de la plaque de dissipation thermique, ladite paroi étant fermée de façon à définir un logement recevant les composants électroniques du module électronique de puissance (200).

5. Equipement électrique selon les revendications 3 et 4, dans lequel, ladite portion externe de la deuxième face de la plaque de dissipation thermique est une surface délimitée par un bord de la plaque de dissipation thermique et une face externe de ladite paroi.

6. Equipement électrique (1) selon l'une des revendications précédentes, comprenant un châssis comportant :
- des premiers organes de retenue configurés pour fixer ladite plaque support de dissipation (30) avec ledit châssis et
- des seconds organes de retenue, configurés pour fixer ledit module électronique de puissance (200) avec ledit châssis,
de sorte que la plaque support de dissipation (30) et le module électronique de puissance (200) sont solidaires l'un de l'autre par l'intermédiaire dudit châssis indépendamment de tout autre moyen de fixation.

7. Equipement électrique (1) selon la revendication précédente, dans lequel :
- ladite plaque support de dissipation (30) comprend des premiers organes de retenue complémentaires pour clipper ladite plaque support de dissipation (30) avec ledit châssis et
- ledit module électronique de puissance (200) comprend des seconds organes de retenue complémentaires pour clipper ledit module électronique de puissance (200) avec ledit châssis.

8. Ensemble électrique (1) comprenant un équipement électrique (1) selon l'une des revendications précédentes, et un dissipateur thermique contre lequel l'équipement électrique est rapporté, la plaque de dissipation thermique, en particulier sa face externe, venant contre une face du dissipateur thermique et l'ensemble étant fixé au dissipateur thermique par l'intermédiaire d'une mise en appui du plot (31) sur la plaque de dissipation thermique et le dissipateur thermique.

9. Onduleur comportant un ensemble électrique selon la revendication précédente.

## Patentansprüche

1. Elektrische Ausrüstung (1), umfassend:
- ein elektronisches Leistungsmodul (200), umfassend ein Gehäuse (208) und elektronische Komponenten, die in dem Gehäuse enthalten sind, und
- eine Elektronikkarte (20), die insbesondere dazu ausgestaltet ist, die elektronischen Komponenten des elektronischen Leistungsmoduls (200) zu steuern;
- eine Ableitungsträgerplattenvorrichtung (30), die Ableitungsträgerplatte (30) umfassend:
- eine Seite, Aufnahmeseite genannt, auf der die Elektronikkarte (20) so aufgenommen ist, dass sie auf einer Zwischenebene gegenüber dem elektronischen Leistungsmodul (200) angeordnet ist, und
wobei die elektrische Ausrüstung **dadurch gekennzeichnet ist, dass** die Ableitungsträgerplatte auch umfasst:
- auf der zu der Aufnahmeseite entgegengesetzten Seite mindestens einen Stift (31) zum Tragen der Ableitungsträgerplatte (30) in einem Aufnahmebereich der Elektronikkarte (20), wobei der mindestens eine Stift (31) ferner eine durchgehende Hülse (32) umfasst, um den Durchgang einer Befestigungsschraube (3) zu ermöglichen, so dass die Ableitungsträgerplatte (30) an einer Wärmeableitungsplatte (2) befestigt wird, die zu dem Gehäuse des elektronischen Leistungsmoduls (200) gehört, und wobei der mindestens eine Stift (31) dazu ausgestaltet ist, aus der Elektronikkarte (20) hervorgegangene Wärme abzuführen, um deren Ableitung über die Wärmeableitungsplatte (2) des elektronischen Leistungsmoduls (200) zu ermöglichen.

2. Elektrische Ausrüstung (1) nach Anspruch 1, wobei eine erste Seite der Wärmeableitungsplatte des elektronischen Leistungsmoduls (200) eine Außenseite zur Wärmeableitung des elektronischen Leistungsmoduls (200) bildet und wobei die elektronischen Komponenten auf einer zweiten Seite der Wärmeableitungsplatte des elektronischen Leistungsmoduls (200) montiert sind, die zu der ersten Seite entgegengesetzt ist.

3. Elektrische Ausrüstung (1) nach Anspruch 2, wobei die zweite Seite der Wärmeableitungsplatte (2) des elektronischen Leistungsmoduls (200) mindestens einen Abschnitt umfasst, der eine Außenfläche des elektronischen Leistungsmoduls (200) bildet, wobei ein Ende des Stifts (31) an dem Abschnitt zur Anlage gelangt.

4. Elektrische Ausrüstung (1) nach einem der vorhergehenden Ansprüche, wobei das Gehäuse eine Wand, insbesondere aus elektrisch isolierendem Material, umfasst, die sich von der zweiten Seite der Wärmeableitungsplatte aus erstreckt, wobei die Wand geschlossen ist, so dass sie eine Aufnahme definiert, die die elektronischen Komponenten des elektronischen Leistungsmoduls (200) aufnimmt.

5. Elektrische Ausrüstung nach den Ansprüchen 3 und 4, wobei der äußere Abschnitt der zweiten Seite der Wärmeableitungsplatte eine Fläche ist, die durch einen Rand der Wärmeableitungsplatte und eine Außenseite der Wand begrenzt wird.

6. Elektrische Ausrüstung (1) nach einem der vorhergehenden Ansprüche, umfassend einen Rahmen, der beinhaltet:
- erste Rückhalteorgane, die dazu ausgestaltet sind, die Ableitungsträgerplatte (30) an dem Rahmen zu befestigen, und
- zweite Rückhalteorgane, die dazu ausgestaltet sind, das elektronische Leistungsmodul (200) an dem Rahmen zu befestigen,
so dass die Ableitungsträgerplatte (30) und das elektronische Leistungsmodul (200) unabhängig von jedem anderen Befestigungsmittel über den Rahmen fest miteinander verbunden sind.

7. Elektrische Ausrüstung (1) nach dem vorhergehenden Anspruch, wobei:
- die Ableitungsträgerplatte (30) komplementär ausgebildete erste Rückhalteorgane umfasst, um die Ableitungsträgerplatte (30) an den Rahmen anzuklipsen und
- das elektronische Leistungsmodul (200) komplementär ausgebildete zweite Rückhalteorgane umfasst, um das elektronische Leistungsmodul (200) an den Rahmen anzuklipsen.

8. Elektrische Einheit (1), umfassend eine elektrische Ausrüstung (1) nach einem der vorhergehenden Ansprüche und einen Wärmeableiter, an den die elektrische Ausrüstung angesetzt ist, wobei die Wärmeableitungsplatte, insbesondere ihre Außenseite, an einer Seite des Wärmeableiters zur Anlage gelangt und wobei die Einheit an dem Wärmeableiter mittels eines Anlegens des Stifts (31) an die Wärmeableitungsplatte und den Wärmeableiter befestigt wird.

9. Wechselrichter mit einer elektrischen Einheit nach dem vorhergehenden Anspruch.

## Claims

1. Electrical apparatus (1) comprising:
- a power electronics module (200) comprising a package (208) and electronic components present in said package, and
- an electronic board (20), in particular configured to control the electronic components of the power electronics module (200);
- a dissipating baseplate device (30), said dissipating baseplate (30) comprising:
- a face, referred to as the receiving face, against which the electronic board (20) is received such that it is disposed on a mezzanine level with respect to the power electronics module (200), and
the electrical apparatus being **characterized in that** said dissipating baseplate also comprises:
- on the opposite side to said receiving face, at least one stud (31) for supporting the dissipating baseplate (30) in a receiving zone of the electronic board (20), said at least one stud (31) further comprising a passage bushing (32) for the passage of a fastening screw (3) such that the dissipating baseplate (30) is fastened to a heat-sink plate (2) which is part of the package of the power electronics module (200), and said at least one stud (31) being configured to drain the heat from the electronic board (20) in order to allow the heat to be dissipated via the heat-sink plate (2) of the power electronics module (200).

2. Electrical apparatus (1) according to Claim 1, wherein a first face of the heat-sink plate of the power electronics module (200) forms an outer heat-sink face of the power electronics module (200) and wherein the electronic components are mounted on an opposite second face of the heat-sink plate of the power electronics module (200) to the first face.

3. Electrical apparatus (1) according to Claim 2, wherein the second face of the heat-sink plate (2) of the power electronics module (200) comprises at least one portion forming an outer surface of the power electronics module (200), one end of said stud (31) bearing against said portion.

4. Electrical apparatus (1) according to one of the preceding claims, wherein said package comprises a wall, in particular made of an electrically insulating material, extending from the second face of the heat-sink plate, said wall being closed such that it defines a recess receiving the electronic components of the power electronics module (200).

5. Electrical apparatus according to Claims 3 and 4, wherein said outer portion of the second face of the heat-sink plate is a surface delimited by an edge of the heat-sink plate and an outer face of said wall.

6. Electrical apparatus (1) according to one of the preceding claims, comprising a frame which has:
- first retaining members configured to fasten said dissipating baseplate (30) to said frame and
- second retaining members configured to fasten said power electronics module (200) to said frame,
such that the dissipating baseplate (30) and the power electronics module (200) are secured to one another via said frame independently of any other fastening means.

7. Electrical apparatus (1) according to the preceding claim, wherein:
- said dissipating baseplate (30) comprises additional first retaining members for clipping said dissipating baseplate (30) to said frame and
- said power electronics module (200) comprises additional second retaining members for clipping said power electronics module (200) to said frame.

8. Electrical assembly (1) comprising an electrical apparatus (1) according to one of the preceding claims, and a heat sink against which the electrical apparatus is fitted, the heat-sink plate, in particular its outer face, coming against a face of the heat sink and the assembly being fastened to the heat sink via the stud (31) bearing against the heat-sink plate and the heat sink.

9. Inverter comprising an electrical assembly according to the preceding claim.
